# EUROPÄISCHE PATENTSCHRIFT

(11) **EP 1 005 072 B1**
(45) Veröffentlichungstag und Bekanntmachung des Hinweises auf die Patenterteilung: **02.01.2002**
(21) Anmeldenummer: 99120902.4
(22) Anmeldetag: 28.10.1999
(51) Int. Cl.: H01L 21/306

(54) **Verfahren zur nasschemischen Behandlung von Halbleiterscheiben**
Method for wet-chemical treatment of semiconductor substrates
Méthode de traitement chimique par voie humide de substrats semiconducteurs

(30) Priorität: 19.11.1998 DE 19853486
(43) Veröffentlichungstag der Anmeldung: 31.05.2000
(73) Patentinhaber: Wacker Siltronic Gesellschaft für Halbleitermaterialien Aktiengesellschaft, 84489 Burghausen (DE)
(72) Erfinder: Brunner, Roland, 84367 Reut (DE); Schwenk, Helmut, Dr., 84489 Burghausen (DE); Zach, Johann, 84347 Pfarrkirchen (DE)
(74) Vertreter: Rimböck, Karl-Heinz, Dr.

(56) Entgegenhaltungen:
- EP-A- 0 731 495
- EP-A- 0 731 498
- EP-A- 0 844 650
- EP-A- 0 859 404
- US-A- 5 803 980
- PATENT ABSTRACTS OF JAPAN vol. 1996, no. 06, 28. Juni 1996 (1996-06-28) & JP 08 031837 A (MITSUBISHI MATERIALS SHILICON CORP;OTHERS: 01), 2. Februar 1996 (1996-02-02)
- MEURIS M ET AL: "THE IMEC CLEAN: A NEW CONCEPT FOR PARTICLE AND METAL REMOVAL ON SI SURFACES" SOLID STATE TECHNOLOGY,US,COWAN PUBL.CORP. WASHINGTON, Bd. 38, Nr. 7, 1995, Seite 109-110,112,114 XP000523398 ISSN: 0038-111X

## Beschreibung

Gegenstand der Erfindung ist ein Verfahren zur naßchemischen Behandlung von Halbleiterscheiben, bei dem die Halbleiterscheiben mit Behandlungsflüssigkeiten behandelt werden, insbesondere ein Verfahren zum Reinigen von Halbleiterscheiben aus Silicium.

Ein Verfahren dieser Gattung ist beispielsweise von M.Meuris et al. in Solid State Technology, July 1995, p. 109 beschrieben worden.

In der EP-731 498 A2 ist ein Verfahren zur naßchemischen Behandlung von Substraten aus Silicium offenbart. Es ist beispielsweise vorgesehen, Scheiben aus Silicium in einem Prozeßbad zunächst mit einem HF enthaltenden Medium zu behandeln und daran anschließend dieses Medium durch Ozon enthaltendes Wasser zu verdrängen.

Durch die vorliegende Erfindung wird ein Verfahren zur Verfügung gestellt, mit dem Halbleiterscheiben besonders effektiv von metallischen Verunreinigungen und Partikeln befreit werden können.

Gegenstand der Erfindung ist ein Verfahren zur naßchemischen Behandlung von Halbleiterscheiben, bei dem die Halbleiterscheiben mit Behandlungsflüssigkeiten in Bädern behandelt werden, wobei die Halbleiterscheiben zuerst in einem Bad mit einer wässerigen HF-Lösung, anschließend in einem Bad mit einer wässerigen O₃-Lösung und schließlich in einem Bad mit einer wässerigen HCl-Lösung behandelt werden, dadurch gekennzeichnet, daß diese Behandlungen eine Behandlungsfolge B₂ bilden, die ansschließlich bei einem pH-Wert kleiner als pH7 durchgeführt wird und nicht durch Spülen der Halbleiterscheiben mit Wasser oder einer anderen Behandlungsflüssigkeit unterbrochen werden darf.

Es hat sich herausgestellt, daß die Aufgabe durch diese Behandlungsfolge, die nicht durch Spülen mit Wasser oder einer anderen Behandlungsflüssigkeit unterbrochen werden darf und ausschließlich bei einem pH-Wert durchgeführt wird, der kleiner als pH 7 ist, gelöst wird. Die erfindungsgemäße Behandlung mit den angegebenen Behandlungsflüssigkeiten erfolgt in Behandlungsbädern, wobei es bevorzugt ist, die Behandlungsflüssigkeit umzuwälzen, das heißt, sie dem entsprechenden Behandlungsbad teilweise zu entnehmen und sie diesem gefiltert wieder zuzuführen. Auf diese Weise werden Aufwendungen für die benötigten Chemikalien und für deionisiertes Wasser gespart. Das Zuführen von frischem Wasser oder anderen Flüssigkeiten in die Behandlungsbäder ist zu unterlassen, da beim Öffnen von Ventilen Druckstöße hervorgerufen werden und Partikel in die Bäder eingetragen werden können. Die erfindungsgemäße Behandlung unterscheidet sich deshalb von einer Spülbehandlung, bei der kontinuierlich oder in Abständen frische Behandlungsflüssigkeit zugeführt wird.

Die Behandlungen bestehend aus der Behandlung der Halbleiterscheiben zuerst in einem Bad mit einer wässerigen HF-Lösung, anschließend in einem Bad mit einer wässerigen O₃-Lösung und schließlich in einem Bad mit einer wässerigen HCI-Lösung bilden eine Behandlungsfolge B₂, der eine Behandlung B₁ der Halbleiterscheiben in einem Bad mit einer wässerigen SC1-Lösung vorangestellt sein kann. Bevorzugt ist eine SC1-Lösung, die NH₄OH und H₂O₂ oder TMAH (= Tetramethylammoniumhydroxid) und H₂O₂ enthält. Der Behandlungsfolge B₂ kann auch eine Trocknungsbehandlung B₃ der Halbleiterscheiben nachgeschaltet sein. Die Trocknungsbehandlung wird vorzugsweise nach dem Schleuder-, Heißwasser-, Isopropanol- oder Marangoniprinzip durchgeführt.

Besonders bevorzugt ist, die Reihenfolge der Behandlung der Halbleiterscheiben gemäß dem Term m*(B₁ + B₂) +B₃ zu gestalten, wobei m eine natürliche Zahl ist und die Behandlung B₁ und die Behandlungsfolge B₂ nacheinander durchgeführt werden und dies m-fach ausgeführt wird, bevor die Trocknungsbehandlung B₃ erfolgt.

Die in der Behandlungsfolge B₂ eingesetzte wässerige HF-Lösung enthält HF vorzugsweise in einer Konzentration von 0,001 bis 2 Gew.-% und gegebenenfalls HCI in einer Konzentration von bis zu 2 Gew.-% und gegebenenfalls ein Tensid. Ein Gemisch aus Alkylbenzolsulfonat und Fettaminpolyglykolether in einer Konzentration von 0,001 bis 2 Gew.-% ist als Tensid-Zusatz besonders bevorzugt. Die in der Behandlungsfolge B₂ eingesetzte wässerige O₃-Lösung enthält O₃ vorzugsweise in einer Konzentration von 1 bis 30 ppm und gegebenenfalls HF in einer Konzentration von 0,0001 bis 2 Gew.-% und wird gegebenenfalls mit Megasonicwellen beaufschlagt. Die in der Behandlungsfolge B₂ zuletzt eingesetzte Flüssigkeit ist eine wässerige HCI-Lösung, die HCI vorzugsweise in einer Konzentration von 0,001 bis 10 Gew.-% enthält. Die Flüssigkeit kann gegebenenfalls O₃ enthalten und und gegebenenfalls mit Megasonicwellen beaufschlagt sein. Die Temperatur des Bads liegt vorzugsweise bei einer Temperatur von Raumtemperatur bis 80 °C.

Die nachfolgende Gegenüberstellung eines Beispiels mit Vergleichsbeispielen zeigt die vorteilhafte Wirkung der Erfindung auf.

Die Tabelle enthält die Ergebnisse (3-Sigma-Werte) von üblichen Zählungen von Partikeln bestimmter Größe (LPD=light point defects), die an jeweils 20 polierten Halbleiterscheiben nach einer naßchemischen Behandlungsfolge und einer für alle Halbleiterscheiben gleichartigen Trocknung durchgeführt wurden.

Das Beispiel (B) umfaßte die Behandlungsfolge: HF-Bad, deionisiertes Wasser/Ozon-Bad, HCl-Bad mit Megasonic-Beaufschlagung. Das Vergleichsbeispiel 1 (V1) umfaßte die Behandlungsfolge: HF-Bad, deionisiertes Wasser/Ozon-Bad, Spülung mit deionisiertem Wasser außerhalb des Bads.
Das Vergleichsbeispiel 2 (V2) umfaßte die Behandlungsfolge: HF-Bad, deionisiertes Wasser/Ozon-Bad mit anschließender Spülung mit deionisiertem Wasser im Bad und Megasonic-Beaufschlagung.

| | | | | |
|---|---|---|---|---|
| LPD (µm) | >0.3 | >0.2 | >0.16 | >0.12 |
| | Anzahl | Anzahl | Anzahl | Anzahl |
| B | 3 | 7 | 30 | 480 |
| | | | | |
| V1 | 4 | 13 | 50 | 550 |
| | | | | |
| V2 | 10 | 50 | 140 | 550 |

## Patentansprüche

1. Verfahren zur naßchemischen Behandlung von Halbleiterscheiben, bei dem die Halbleiterscheiben mit Behandlungsflüssigkeiten in Bädern behandelt werden, wobei die Halbleiterscheiben zuerst in einem Bad mit einer wässerigen HF-Lösung, anschließend in einem Bad mit einer wässerigen O₃-Lösung und schließlich in einem Bad mit einer wässerigen HCI-Lösung behandelt werden, **dadurch gekennzeichnet, daß** diese Behandlungen eine Behandlungsfolge B₂ bilden, die ansschließlich bei einem pH-Wert kleiner als pH7 durchgeführt wird und nicht durch Spülen der Halbleiterscheiben mit Wasser oder einer anderen Behandlungsflüssigkeit unterbrochen wird.

2. Verfahren nach Anspruch 1, **dadurch gekennzeichnet, daß** der Behandlungsfolge B₂ eine Behandlung B₁ der Halbleiterscheiben mit einer wässerigen Lösung, die NH₄OH und H₂O₂ oder TMAH (= Tetramethylammoniumhydroxid) und H₂O₂ enthält, vorangestellt wird.

3. Verfahren nach Anspruch 1 oder Anspruch 2, **dadurch gekennzeichnet, daß** der Behandlungsfolge B₂ eine Trocknungsbehandlung B₃ der Halbleiterscheiben nachgeschaltet wird.

4. Verfahren nach Anspruch 3, **dadurch gekennzeichnet, daß** die Reihenfolge der Behandlung der Halbleiterscheiben gemäß dem Term m*(B₁ + B₂) +B₃ erfolgt, wobei m eine natürliche Zahl ist und die Behandlung B₁ und die Behandlungsfolge B₂ nacheinander durchgeführt werden und dies m-fach ausgeführt wird, bevor die Trocknungsbehandlung B₃ erfolgt.

5. Verfahren nach einem der Ansprüche 1 bis 4, **dadurch gekennzeichnet, daß** die wässerige HF-Lösung HF in einer Konzentration von 0,001 bis 2 Gew.-% und gegebenenfalls HCl in einer Konzentration von bis zu 2 Gew.-% und gegebenenfalls ein Tensid enthält.

6. Verfahren nach einem der Ansprüche 1 bis 5, **dadurch gekennzeichnet, daß** die wässerige O₃-Lösung O₃ in einer Konzentration von 1 bis 30 ppm enthält und gegebenenfalls mit Megasonicwellen beaufschlagt wird.

7. Verfahren nach einem der Ansprüche 1 bis 6, **dadurch gekennzeichnet, daß** die in der Behandlungsfolge B₂ zuletzt eingesetzte Behandlungsflüssigkeit Ozon enthält und gegebenenfalls mit Megasonicwellen beaufschlagt wird.

8. Verfahren nach einem der Ansprüche 3 bis 7, **dadurch gekennzeichnet, daß** die Trocknungsbehandlung nach dem Schleuder-, Heißwasser-, Isopropanol- oder Marangoniprinzip durchgeführt wird.

9. Verfahren nach einem der Ansprüche 2 bis 8, **dadurch gekennzeichnet, daß** jede Behandlung B₁ mit einer Behandlungsflüssigkeit in einem Bad durchgeführt wird.

## Claims

1. Process for the wet chemical treatment of semiconductor wafers, in which the semiconductor wafers are treated with treatment liquids in baths, **characterized in that** the semiconductor wafers are firstly treated in a bath with an aqueous HF solution, then in a bath with an aqueous O₃ solution and finally in a bath with an aqueous HCl solution, **characterized in that** these treatments form a treatment sequence B₂ which is carried out exclusively at a pH lower than pH7 and is not interrupted by rinsing the semiconductor wafers with water or another treatment liquid.

2. Process according to Claim 1, **characterized in that** the treatment sequence B₂ is preceded by a treatment B₁ of the semiconductor wafers with an aqueous solution which contains NH₄OH and H₂O₂ or TMAH (= tetramethylammonium hydroxide) and H₂O₂.

3. Process according to Claim 1 or Claim 2, **characterized in that** the treatment sequence B₂ is followed by a treatment B₃ of drying the semiconductor wafers.

4. Process according to Claim 3, **characterized in that** the treatment of the semiconductor wafers is sequenced according to the term m* (B₁ + B₂) + B₃, m being a natural number and the treatment B₁ and the treatment sequence B₂ being carried out in succession, and this taking place m times, before the drying treatment B₃ is performed.

5. Process according to one of Claims 1 to 4, **characterized in that** the aqueous HF solution contains HF in a concentration of from 0.001 to 2% by weight and optionally HCl in a concentration of up to 2% by weight and optionally a surfactant.

6. Process according to one of Claims 1 to 5, **characterized in that** the aqueous O₃ solution contains O₃ in a concentration of from 1 to 30 ppm and is optionally exposed to megasonic waves.

7. Process according to one of Claims 1 to 6, **characterized in that** the treatment liquid used last in the treatment sequence B₂ contains ozone and is optionally exposed to megasonic waves.

8. Process according to one of Claims 3 to 7, **characterized in that** the .drying treatment is carried out using the centrifugal, hot water, isopropanol or marangoni principle.

9. Process according to one of Claims 2 to 8, **characterized in that** each treatment B₁ is carried out with one treatment liquid in one bath.

## Revendications

1. Procédé de traitement par voie chimique humide de pastilles semi-conductrices, lors duquel les pastilles semi-conductrices sont traitées dans des bains à l'aide de liquides de traitement, les pastilles semi-conductrices étant tout d'abord traitées dans un bain à l'aide d'une solution aqueuse de HF, ensuite dans un bain à l'aide d'une solution aqueuse de O₃, et finalement dans un bain à l'aide d'une solution aqueuse de HCl, **caractérisé en ce que** ces traitements forment une séquence de traitements B₂ qui est effectuée exclusivement à une valeur pH inférieure au pH de 7 et qui n'est pas interrompue par rinçage des pastilles semi-conductrices à l'aide d'eau ou à l'aide d'un autre liquide de traitement.

2. Procédé selon la revendication 1, **caractérisé en ce que** la séquence de traitements B₂ est précédée d'un traitement B₁ des pastilles semi-conductrices à l'aide d'une solution aqueuse qui contient NH₄OH et H₂O₂ ou HTMA ( = hydroxyde de tétraméthylammonium).

3. Procédé selon la revendication 1 ou la revendication 2, **caractérisé en ce que** la séquence de traitements B₂ est suivie d'un traitement de séchage B₃ des pastilles semi-conductrices.

4. Procédé selon la revendication 3, **caractérisé en ce que** la séquence du traitement des pastilles semi-conductrices se fait conformément au terme m*(B₁ + B₂) + B₃, m étant un chiffre naturel et le traitement B₁ et la séquence de traitements B₂ étant effectués l'un après l'autre, et ceci à m reprises, avant l'exécution du traitement de séchage B₃.

5. Procédé selon l'une quelconque des revendications 1 à 4, **caractérisé en ce que** la solution aqueuse de HF contient HF dans une concentration de 0,001 à 2% en poids et, le cas échéant, HCl dans une concentration allant jusqu'à 2% en poids et, le cas échéant, un agent tensioactif.

6. Procédé selon l'une quelconque des revendications 1 à 5, **caractérisé en ce que** la solution aqueuse de O₃ contient O₃ dans une concentration de 1 à 30 ppm et est soumise, le cas échéant, à des ondes mégasoniques.

7. Procédé selon l'une quelconque des revendications 1 à 6, **caractérisé en ce que** le liquide de traitement utilisé en dernier lieu au cours de la séquence de traitements B₂ contient de l'ozone et, le cas échéant, est soumis à des ondes mégasoniques ou à hautes fréquences.

8. Procédé selon l'une quelconque des revendications 3 à 7, **caractérisé en ce que** le traitement de séchage est effectué conformément à la méthode principe de centrifugation, à la méthode à l'eau chaude, à la méthode à l'isopropanol ou à la méthode par effet Marangoni.

9. Procédé selon l'une quelconque des revendications 2 à 8, **caractérisé en ce que** chaque traitement B₁ est effectué dans un bain à l'aide d'un liquide de traitement.
